# EUROPEAN PATENT APPLICATION

(11) **EP 2 023 612 A1**
(43) Date of publication of application: **11.02.2009**
(21) Application number: 08158966.5
(22) Date of filing: 25.06.2008
(51) Int. Cl.: H04N 5/268

(54) **Bus identification circuit**

(30) Priority: 25.07.2007 TR 200705170
(71) Applicant: Vestel Elektronik Sanayi ve Ticaret A.S., 45030 Manisa (TR)
(72) Inventor: Gökkaya, Utku, 34469 Istanbul (TR)
(74) Representative: Cayli, Hülya

(57) **Abstract**

An apparatus and method is disclosed for automatic detecting and selecting input audio and video signals, and for providing these input signals over a single output connector and using a single signal line. The selection of the audio and video input signals is realized by a bus identification circuit which can recognize the load of the connected sink devices and can realize switching of the video and audio input signals.

## Description

### Technical Field

The present invention relates to a method and apparatus which automatically select and provide the appropriate input signal out of the ones with different characteristics to a sink device connected to a connector.

### Prior Art

Modern multimedia devices are conceived to automatically detect the presence of external baseband signals, such as video and audio signals. They have internal switching circuitry to select demodulated audio and video signals received by the tuner, or video and audio signals applied to auxiliary inputs. This implies that the user may select between broadcast signals received from the antenna or from cable or auxiliary signals coming from a video recorder.

Most of televisions therefore use specific video and audio signal lines, generally dedicated to carry a single video or audio signal. In case of presence of a single output connector (for video or for audio) it is then possible to output only one source.

The present invention overcomes this limitation, so that both video and audio signal can be outputted from a single connector.

The selection of video or audio signal to be properly sent to the output is realized automatically by detecting the presence of the sink source type.

This is possible since the sink source type can be defined on the base of the characteristics of the signal line.

To identify the video and audio signals on the basis of their characteristics it is employed a bus identification circuit; the latter defines the bus characteristics and, depending on them, it is able to identify and automatically switch the connections to the audio and video sink device.

The need for circuitry optimization and reduction of the number of connectors is well known in the art and underlined in EP0392552, as regards specifically TV devices. The document deals with a switching system for an audio/video rendering system having S-video capability. Specifically, the switching system of EP0392552 resolves the problem of coupling audio signals associated with baseband video signal, especially for S-Video.

Another contribution in the prior art of automatic switching using a single line can be found in JP6035503. In the disclosed circuit, the system decides to connect directly the input signal to the output or to provide the input signal after buffering.

JP63050131 also deals with a signal selecting device for selecting which common buses can be used. Clock buses are used for driving signals out of flip-flop circuitry. The method disclosed in JP63050131 checks the inputs, while the proposed solution selects the signal on the base of the output resistance. The system defined in JP63050131 can use different types of signal sources, not just audio and video, but the structure of the circuitry used for the decision block is completely different. The decision block is composed of digital circuit elements and gates that introduce additional costs in the implementation of the system.

The need for circuitry optimization and reduction of the number of connectors is solved in the present invention where both video and audio signal can be outputted from single connector and the selection of the signal is realized automatically by detecting the type of the sink source.

### Brief Description of the Invention

The present invention relates to a method and apparatus for automatically detecting the characteristics and the source signal type on the base of the sink device type. This apparatus is the combination of two sections: the first section deals with the automatic detection of the characteristics of the sink device, while the second section represents the real switching element that provides the correct signal type for the automatic detection of the sink device type.

An immediate advantage of the invention is that it provides the possibility to use same signal line for different signal source type connectivity. The invention can be applied to all signal output devices, since the detection circuitry can characterise the signal line and defines which kind of signal sink is connected. The characterisation of the signal sink type allows automatically deciding on which signal should be outputted.

Another advantage of the invention is that the automatic detection of the sink device does not require any user or software control of the output signal type.

The apparatus for automatically detecting and selecting input signals of different technical characteristics in its first embodiment is characterized in that the two input signals are output over a unique output connector and the two input signals use the same output line to reach the output connector.

Various objects, features and advantages of the present invention will become apparent to those skilled in the art upon reading the following detailed description, when taken in conjunction with the accompanying drawings.

### The Object of the Invention

The object of the present invention is to provide an apparatus and method for automatically selecting the input signals in order to output the input signals of different characteristics over a unique output connector by using a single signal line.

### Brief Description of the Drawings:

Figure-1 Block diagram of the input signals and the bus identification circuitry
Figure-2 Bus identification circuitry

### Detailed Description of the Invention

The present invention provides a single connector use for two different output signal sources.

The present invention can be applied in devices with different signal outputs, if the characteristic of the line is different depending to the signal type.

As an example, video and audio signal line characteristics are different by specification, therefore by using the difference of the characteristics of the line connected to the sink device type, they can be detected automatically by the present architecture.

In the invention, automatic line characteristic detection and switching to the proper signal source dedicated to the sink device are proposed.

An exemplary embodiment is as follows: in a multimedia device, three connectors are used for Right, Left and Subwoofer audio output. This configuration provides only audio connectivity to the audio amplifier sink device, but with the addition of the invented circuitry, the video output (for example CVBS output) can also share the connector which is used only for the subwoofer output. Therefore the present architecture provides connectivity for both the audio amplifier and the video recorder. If the connector is connected to the audio sink device subwoofer, the signal output is actively selected and if the line is connected to the video recorder or a video display source then the video is automatically selected and actively provided to the output. By employing the same output connectivity architecture, two totally different sink devices can be connected and this connectivity is automatically provided by the circuit of the invention.

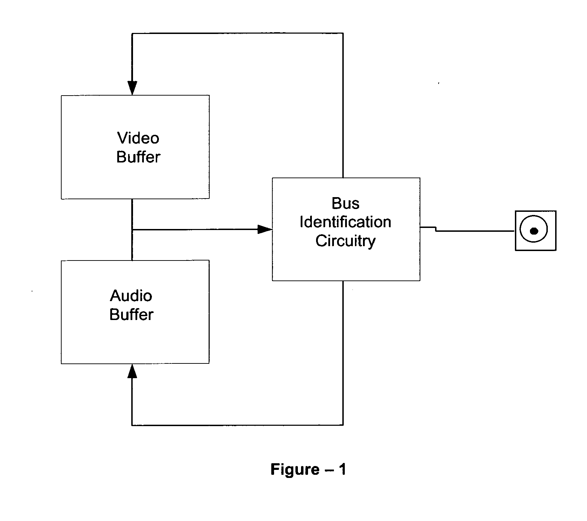

The block diagram of Figure 1 comprises three elements: a video buffer, an audio buffer and a bus identification circuitry. The video and audio buffers can be standard signal buffers like emitter followers. The third block instead has the functionality of a signal buffer and also of a bus characteristic identification. Since video and audio signals have different bus characteristic by definition, the bus identification circuitry can identify whether the sink device is an audio or a video input sink. This identification and detection circuit drives the proper audio or video signal to the output. The identification circuit is the base of the invention which detects the characteristic of the signal bus, this characteristic defining which of the outputs will be selected automatically.

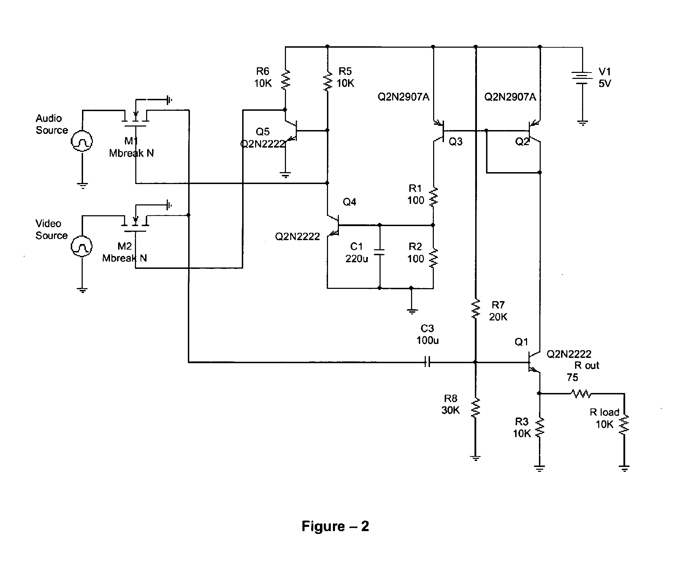

The schematic diagram of the invention is given in figure 2. Two different sources, audio and video sources, are connected to the transistors M1 and M2 respectively. These transistors are controlled by the bus identification circuitry. Depending on the sink device, either M1 or M2 is on: specifically, if the impedance of the sink device seen by the identification circuit is over threshold impedance- in this embodiment, as an example set to 200 ohms-, then the video source is activated, implying that the M2 transistor is on and M1 is off. If M2 is not on, then M1 is on, since at the default (normal) state M1 is on.

Therefore the bus identification circuitry defines the sink device and depending to the sink device type the audio or video source is selected.

Q1 is the bus driving transistor; Q2 and Q3 are the current mirrors, wherein current is supplied to the sink device in accordance with the detection of the right sink by the identification circuit. The current level defines the sink type and depending on the sink type, video or audio sources are switched automatically. Q4 and Q5 are inverters for switching control.

Obviously the idea of using a single output for more than one input can also be realized with other switching circuitry configurations well known in the literature; as an example it could be employed a MUX architecture.

The circuit of the invention, differently from the prior art, solves the problem of decreasing the number of connections with a simple and low cost solution.

## Claims

1. An apparatus for automatically selecting input signals of different technical characteristics, **characterized in that:**
- the two input signals are output over a unique output connector
- the two input signals use the same output line to reach the output connector
- it comprises a bus identification circuitry

2. The apparatus of claim 1 wherein said input signals of different technical characteristics are video and audio signals and said audio and video signals are provided to audio or video sink devices.

3. The apparatus of claim 2 comprising a video buffer and an audio buffer.

4. The apparatus of claim 1, wherein said bus identification circuit selects the input signals by recognizing the impedance of the said audio or video sink devices.

5. The apparatus of claim 4, wherein said video and audio signals of said sink devices are connected via a transistor and the current is provided by the bus identification circuitry.

6. The apparatus of claim 5 wherein the bus identification circuitry comprises a current mirror for providing the current to the connected sink device and two inverters for switching control of the input signals.

7. The apparatus of claim 6 wherein the sink device is an audio sink device if the impedance seen by the bus identification circuitry is over threshold impedance and a video sink device otherwise.

8. The apparatus of claim 7, wherein said video buffer and audio buffer are emitter followers.

9. The apparatus of claim 7, wherein the said threshold impedance is 200 ohms.

10. Method for providing video and audio input signals over a single output connector by using a single signal line, comprising automatic detection and selection of input audio and video signals.

11. The method of claim 9 wherein the selection of said audio and video input signals is realized by a bus identification circuit, said bus identification circuit recognizing the load of connected sink devices providing said video and audio input signals and providing the current to said load via a current mirror and two inverters for realizing the switching.
